(19) Europäisches Patentamt
European Patent Office
Office européen des brevets

(11) **EP 4 231 333 A1**

(12) **EUROPEAN PATENT APPLICATION**
published in accordance with Art. 153(4) EPC

(43) Date of publication:
**23.08.2023 Bulletin 2023/34**

(21) Application number: **21880010.0**

(22) Date of filing: **08.10.2021**

(51) International Patent Classification (IPC):
***H01L 21/3065*** (2006.01)

(52) Cooperative Patent Classification (CPC):
**H01L 21/3065**

(86) International application number:
**PCT/JP2021/037425**

(87) International publication number:
**WO 2022/080271 (21.04.2022 Gazette 2022/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **15.10.2020 JP 2020173918**

(71) Applicant: **Resonac Corporation
Tokyo 105-8518 (JP)**

(72) Inventor: **SUZUKI, Atsushi
Tokyo 105-8518 (JP)**

(74) Representative: **Strehl Schübel-Hopf & Partner
Maximilianstrasse 54
80538 München (DE)**

(54) **ETCHING GAS, METHOD FOR PRODUCING SAME, ETCHING METHOD, AND METHOD FOR PRODUCING SEMICONDUCTOR ELEMENT**

(57) There are provided an etching gas and an etching method capable of selectively etching an etching object containing silicon as compared with a non-etching object. The etching gas contains fluorobutene represented by a general formula $C_4H_xF_y$, in which x is 1 or more and 7 or less, y is 1 or more and 7 or less, and x + y is 8. The etching gas contains carbonyl fluoride as impurities and the concentration of carbonyl fluoride is 100 ppm by mass or less. The etching method includes an etching step of bringing the etching gas into contact with a member to be etched (12) having an etching object which is an object to be etched by the etching gas and a non-etching object which is not an object to be etched by the etching gas, and selectively etching the etching object as compared with the non-etching object. The etching object contains silicon.

FIG. 1

Processed by Luminess, 75001 PARIS (FR)

EP 4 231 333 A1

**Description**

Technical Field

The present invention relates to an etching gas, a method for producing the same, an etching method, and a method for producing a semiconductor device.

Background Art

In a semiconductor production step, dry etching is used for patterning or removal of silicon compounds, such as silicon oxides and silicon nitrides. The dry etching is required to have high etching selectivity. More specifically, the dry etching is required to be able to selectively etch the silicon compounds as compared with a resist or a mask used for patterning.

Various etching gases satisfying this requirement have been proposed. PTL 1, for example, discloses an etching gas containing hexafluoroisobutene. PTL 2 discloses an etching gas containing hexafluorobutene and hexafluorobutyne.

Citation List

Patent Literatures

> PTL 1: JP 6257638 B
> PTL 2: JP 6462699 B

Summary of Invention

Technical Problem

However, etching using the etching gases disclosed in PTLS 1, 2 has sometimes resulted in insufficient etching selectivity.

It is an object of the present invention to provide an etching gas capable of selectively etching an etching object which is an object to be etched by the etching gas as compared with a non-etching object which is not an object to be etched by the etching gas when the etching is performed by bringing the etching gas into contact with a member to be etched having the etching object and the non-etching object, a method for producing the same, an etching method, and a method for producing a semiconductor device.

Solution to Problem

To achieve the above-described object, one aspect of the present invention is as described in [1] to [11] below.

> [1] An etching gas contains: fluorobutene represented by a general formula $C_4H_xF_y$, in which x is 1 or more and 7 or less, y is 1 or more and 7 or less, and x + y is 8, in which
> the etching gas contains carbonyl fluoride as impurities and the concentration of carbonyl fluoride is 100 ppm by mass or less.
> [2] The etching gas according to [1], further contains hydrogen fluoride as the impurities, and the concentration of hydrogen fluoride is 100 ppm by mass or less.
> [3] A method for producing the etching gas according to [1] or [2], includes:

>> a dehydration step of applying dehydration treatment to crude fluorobutene which is the fluorobutene containing water and an oxygen gas; and
>> a deoxidizing gas step of applying deoxidizing gas treatment to the crude fluorobutene.

> [4] The method for producing the etching gas according to [3], in which the deoxidizing gas step is performed after the dehydration step.
> [5] The method for producing the etching gas according to [3] or [4], in which the dehydration treatment is treatment of bringing the crude fluorobutene into contact with an adsorbent to cause the adsorbent to adsorb the water.
> [6] The method for producing the etching gas according to any one of [3] to [5], further includes: a filling step of filling a filling vessel with the fluorobutene having undergone the dehydration step and the deoxidizing gas step.

[7] An etching method includes: an etching step of bringing the etching gas according to [1] or [2] into contact with a member to be etched having an etching object which is an object to be etched by the etching gas and a non-etching object which is not an object to be etched by the etching gas, and selectively etching the etching object as compared with the non-etching object, in which the etching object contains silicon.

[8] The etching method according to [7], in which the etching gas is filled into a filling vessel, a gas phase part in the filling vessel has a concentration of carbonyl fluoride of 100 ppm by mass or less, and, in the etching step, the etching object is etched by extracting the gas phase part from the filling vessel and bringing the gas phase part into contact with the member to be etched.

[9] The etching method according to [7] or [8], in which the etching gas is a gas containing only the fluorobutene or a mixed gas containing the fluorobutene and a dilution gas.

[10] The etching method according to [9], in which the dilution gas is at least one selected from a nitrogen gas, helium, argon, neon, krypton, and xenon.

[11] A method for producing a semiconductor device using the etching method according to any one of [7] to [10],

the member to be etched being a semiconductor substrate having the etching object and the non-etching object, and the method includes:

a treatment step of removing at least a part of the etching object from the semiconductor substrate by the etching.

Advantageous Effects of Invention

According to the present invention, the etching object containing silicon can be selectively etched as compared with the non-etching object.

Brief Description of Drawings

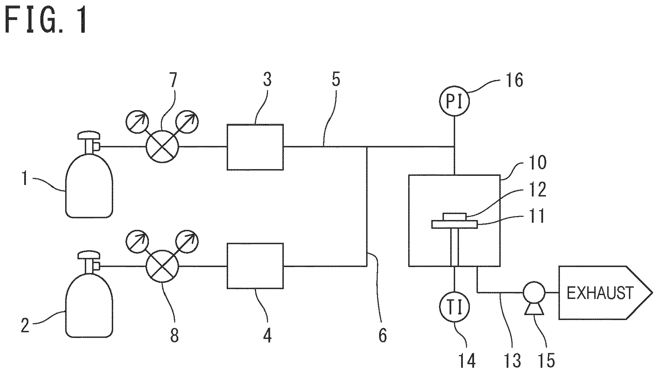

FIG. 1 is a schematic view of one example of an etching system for explaining one embodiment of an etching method according to the present invention.

Description of Embodiments

Hereinafter, one embodiment of the present invention will be described. This embodiment describes one example of the present invention, and the present invention is not limited to this embodiment. Further, this embodiment can be variously altered or modified and embodiments obtained by such alternations or modifications may also be included in the present invention.

An etching gas according to this embodiment is an etching gas containing fluorobutene represented by a general formula $C_4H_xF_y$, in which x is 1 or more and 7 or less, y is 1 or more and 7 or less, and x + y is 8, and the etching gas contains carbonyl fluoride ($COF_2$) as impurities and the concentration of carbonyl fluoride is 100 ppm by mass or less.

An etching method according to this embodiment includes an etching step of bringing the etching gas according to this embodiment into contact with a member to be etched having an etching object which is an object to be etched by the etching gas and a non-etching object which is not an object to be etched by the etching gas, and selectively etching the etching object as compared with the non-etching object. In the etching method according to this embodiment, the etching object contains silicon (Si).

When the etching gas is brought into contact with the member to be etched, the etching object containing silicon reacts with the fluorobutene above in the etching gas, and therefore the etching of the etching object proceeds. On the other hand, the non-etching object, such as a mask, hardly reacts with the fluorobutene above, and therefore the etching of the non-etching objects hardly proceeds. Therefore, according to the etching method of this embodiment, the etching object can be selectively etched as compared with the non-etching object (i.e., high etching selectivity is obtained).

Further, the fluorobutene above reacts and forms a polymer during dry etching, and the non-etching object is coated with a film of this polymer to be protected from the etching. Therefore, the etching of the non-etching object becomes more difficult to proceed, and therefore the etching selectivity is further increased when the etching is performed using the etching gas containing the fluorobutene above.

Carbonyl fluoride is highly reactive to both the etching object, such as silicon oxides and silicon nitrides, and the non-etching object, such as a mask. Therefore, when the member to be etched is etched using the etching gas containing carbonyl fluoride, there is a risk that both the etching object and the non-etching object are etched, resulting in insufficient etching selectivity. Therefore, to increase the etching selectivity, it is necessary to reduce the concentration of carbonyl fluoride in the etching gas.

More specifically, the concentration of carbonyl fluoride in the etching gas needs to be 100 ppm by mass or less and is preferably 50 ppm by mass or less and more preferably 10 ppm by mass or less. When etching is performed using the etching gas with a concentration of carbonyl fluoride within the ranges above, the non-etching object is difficult to be etched, and therefore the etching selectivity of the etching object to the non-etching object becomes high. Although a method for measuring the concentration of carbonyl fluoride is not particularly limited, carbonyl fluoride can be quantified by infrared spectroscopy, for example.

Hydrogen fluoride (HF) also has the same action as that of carbonyl fluoride, and is highly reactive to both the etching object, such as silicon oxides and silicon nitrides, and the non-etching object, such as a mask, and therefore it is preferable that the concentration of hydrogen fluoride in the etching gas is low. More specifically, when the etching gas further contains hydrogen fluoride as the impurities, the concentration of hydrogen fluoride in the etching gas is preferably 100 ppm by mass or less, more preferably 50 ppm by mass or less, and still more preferably 10 ppm by mass or less. Although a method for measuring the concentration of hydrogen fluoride is not particularly limited, hydrogen fluoride can be quantified by infrared spectroscopy, for example.

As described above, the etching gas according to this embodiment has a low concentration of carbonyl fluoride, and therefore, when the dry etching of the member to be etched is performed using the etching gas according to this embodiment, the non-etching object is difficult to be etched and the etching object can be selectively etched as compared with the non-etching object, so that the etching selectivity becomes high.

For example, an etching selectivity ratio, which is a ratio of the etching rate of the etching object to the etching rate of the non-etching object, tends to be 10 or more. The etching selectivity ratio is preferably 10 or more, more preferably 30 or more, and still more preferably 50 or more.

Carbonyl fluoride and hydrogen fluoride are impurities derived from the fluorobutene above. The reason why carbonyl fluoride and hydrogen fluoride are easily contained as the impurities in the fluorobutene above is described below.

The fluorobutene above contains a small amount of an oxygen gas ($O_2$) and water ($H_2O$) in many cases. However, when the oxygen concentration in fluorobutene exceeds 1000 ppm by mass, fluorobutene reacts with the oxygen gas to generate carbonyl fluoride and hydrogen fluoride as represented in the following formula. The presence of the water in fluorobutene accelerates the reaction represented by the following formula.

$$C_4H_xF_y + (4-(y-x)/4)O_2 \rightarrow (y-x)/2COF_2 + xHF + (4-(y-x)/2)CO_2$$

As described above, carbonyl fluoride and hydrogen fluoride are generated by the reaction of the fluorobutene above and the oxygen gas. Therefore, when the etching gas according to this embodiment containing the fluorobutene above is produced, it is necessary to remove the water and the oxygen gas from the fluorobutene above to reduce the concentration of carbonyl fluoride and hydrogen fluoride.

More specifically, the method for producing the etching gas according to this embodiment includes a dehydration step of applying dehydration treatment to crude fluorobutene which is the fluorobutene above containing the water and the oxygen gas, and a deoxidizing gas step of applying deoxidizing gas treatment to the crude fluorobutene. The order of carrying out the dehydration step and the deoxidizing gas step is not particularly limited, and either step may be performed first. If possible, the dehydration step and the deoxidizing gas step may be performed at the same time.

The etching in the present invention means processing the member to be etched into a predetermined shape (for example, three-dimensional shape) by partially or entirely removing the etching object possessed by the member to be etched (for example, processing the etching object in a film shape containing a silicon compound possessed by the member to be etched to have a predetermined film thickness).

The etching method according to this embodiment can be utilized for producing semiconductor devices. More specifically, a method for producing a semiconductor device according to this embodiment is a method for producing a semiconductor device using the etching method according to this embodiment. The member to be etched is a semiconductor substrate having the etching object and the non-etching object. The method includes a treatment step of removing at least a part of the etching object from the semiconductor substrate by etching.

The etching method according to this embodiment can accurately etch the etching object, and therefore is usable for producing semiconductor devices, such as 3D-NAND flash memories and logic devices. Further, the etching method according to this embodiment can be expected to contribute to further miniaturization and higher integration of semiconductor devices.

Hereinafter, the etching gas, the method for producing the etching gas, the etching method, and the method for producing a semiconductor device according to this embodiment are described in more detail.

[Fluorobutene]

Fluorobutene contained in the etching gas according to this embodiment is represented by a general formula $C_4H_xF_y$ and satisfies the following three conditions: x is 1 or more and 7 or less, y is 1 or more and 7 or less, and x + y is 8 in the general formula. The type of the fluorobutene is not particularly limited insofar as the above-described requirements are satisfied, and both linear fluorobutene and branched fluorobutene (isobutene) are usable, and fluoro-1-butene and the like and fluoro-2-butene and the like are preferably usable.

Specific examples of fluoro-1-butene include $CHF_2-CF_2-CF=CF_2$, $CF_3-CF_2-CF=CHF$, $CF_3-CHF-CF=CF_2$, $CF_3-CF_2-CH=CF_2$, $CHF_2-CHF-CF=CF_2$, $CHF_2-CF_2-CF=CHF$, $CF_3-CHF-CF=CHF$, $CF_3-CF_2-CH=CHF$, $CF_3-CHF-CH=CF_2$, $CHF_2-CF_2-CH=CF_2$, $CH_3-CF_2-CF=CF_2$, $CH_2F-CHF-CF=CF_2$, $CH_2F-CF_2-CH=CF_2$, $CH_2F-CF_2-CF=CHF$, $CHF_2-CH_2-CF=CF_2$, $CHF_2-CHF-CH=CF_2$, $CHF_2-CHF-CF=CHF$, $CHF_2-CF_2-CH=CHF$, $CHF_2-CF_2-CF=CH_2$, $CF_3-CH_2-CH=CF_2$, $CF_3-CH_2-CF=CHF$, $CF_3-CHF-CH=CHF$, $CF_3-CHF-CF=CH_2$, $CF_3-CF_2-CH=CH_2$, $CH_3-CHF-CF=CF_2$, $CH_3-CF_2-CH=CF_2$, $CH_3-CF_2-CF=CHF$, $CH_2F-CH_2-CF=CF_2$, $CH_2F-CHF-CH=CF_2$, $CH_2F-CHF-CF=CHF$, $CH_2F-CF_2-CH=CHF$, $CH_2F-CF_2-CF=CH_2$, $CHF_2-CH_2-CH=CF_2$, $CHF_2-CH_2-CF=CHF$, $CHF_2-CHF-CH=CHF$, $CHF_2-CHF-CF=CH_2$, $CHF_2-CF_2-CH=CH_2$, $CF_3-CH_2-CH=CHF$, $CF_3-CH_2-CF=CH_2$, $CF_3-CHF-CH=CH_2$, $CH_3-CH_2-CF=CF_2$, $CH_3-CHF-CH=CF_2$, $CH_3-CHF-CF=CHF$, $CH_3-CF_2-CH=CHF$, $CH_3-CF_2-CF=CH_2$, $CH_2F-CH_2-CH=CF_2$, $CH_2F-CH_2-CF=CHF$, $CH_2F-CHF-CH=CHF$, $CH_2F-CHF-CF=CH_2$, $CH_2F-CF_2-CH=CH_2$, $CHF_2-CH_2-CH=CHF$, $CHF_2-CH_2-CF=CH_2$, $CHF_2-CHF-CH=CH_2$, $CF_3-CH_2-CH=CH_2$, $CH_3-CH_2-CH=CF_2$, $CH_3-CH_2-CF=CHF$, $CH_3-CHF-CH=CHF$, $CH_3-CHF-CF=CH_2$, $CH_3-CF_2-CH=CH_2$, $CH_2F-CH_2-CH=CHF$, $CH_2F-CH_2-CF=CH_2$, $CH_2F-CHF-CH=CH_2$, $CHF_2-CH_2-CH=CH_2$, $CH_3-CH_2-CH=CHF$, $CH_3-CH_2-CF=CH_2$, $CH_3-CHF-CH=CH_2$, and $CH_2F-CH_2-CH=CH_2$.

Specific examples of fluoro-2-butene include $CHF_2-CF=CF-CF_3$, $CF_3-CH=CF-CF_3$, $CH_2F-CF=CF-CF_3$, $CHF_2-CH=CF-CF_3$, $CHF_2-CF=CF-CHF_2$, $CF_3-CH=CH-CF_3$, $CH_3-CF=CF-CF_3$, $CH_2F-CH=CF-CF_3$, $CH_2F-CF=CH-CF_3$, $CH_2F-CF=CF-CHF_2$, $CHF_2-CH=CH-CF_3$, $CHF_2-CF=CH-CHF_2$, $CH_3-CH=CF-CF_3$, $CH_3-CF=CH-CF_3$, $CH_3-CF=CF-CHF_2$, $CH_2F-CH=CH-CF_3$, $CH_2F-CH=CF-CHF_2$, $CH_2F-CF =CH-CHF_2$, $CH_2F-CF=CF-CH_2F$, $CHF_2-CH=CH-CHF_2$, $CH_3-CH=CH-CF_3$, $CH_3-CH=CF-CHF_2$, $CH_3-CF=CH-CHF_2$, $CH_3-CF=CF-CH_2F$, $CH_2F-CF=CH-CH_2F$, $CH_2F-CH=CH-CHF_2$, $CH_3-CH=CH-CHF_2$, $CH_3-CH=CF-CH_2F$, $CH_3-CF=CH-CH_2F$, $CH_3-CF=CF-CH_3$, $CH_2F-CH=CH-CH_2F$, $CH_3-CH=CH-CH_2F$, and $CH_3-CH=CF-CH_3$.

These fluorobutenes may be used alone or in combination of two or more types. Some of the fluorobutenes above have cis-trans isomers, but both the cis-type and trans-type fluorobutenes are usable for the etching gas according to this embodiment.

Among the fluorobutenes above, those having a boiling point at 1 atm of 50°C or less are preferable, and those having a boiling point at 1 atm of 40°C or less are more preferable. When the boiling point at 1 atm is within the ranges above, a gas of the fluorobutene is difficult to be liquefied inside a pipe or the like introducing the gas of the fluorobutene when the gas of the fluorobutene is introduced into, for example, a plasma etching system. Therefore, the occurrence of faults due to the liquefaction of the gas of the fluorobutene can be suppressed, so that the plasma etching treatment can be efficiently performed.

[Etching gas]

The etching gas is a gas containing the fluorobutenes above. The etching gas may be a gas containing only the fluorobutenes above or may be a mixed gas containing the fluorobutenes above and a dilution gas. The dilution gas is preferably inert to fluorobutene and the member to be etched. The etching gas may also be a mixed gas containing the fluorobutenes above, the dilution gas, and an additive gas.

The dilution gas is preferably an inert gas, and specifically at least one selected from a nitrogen gas ($N_2$), helium (He), neon (Ne), argon (Ar), krypton (Kr), and xenon (Xe) is usable.

As the additive gas, a gas of fluorocarbon and a gas of hydrofluorocarbon are usable, for example. Specific examples of fluorocarbon include carbon tetrafluoride ($CF_4$), hexafluoromethane ($C_2F_6$), and octafluoropropane ($C_3F_8$). Specific examples of hydrofluorocarbon include $CF_3H$, $CF_2H_2$, $CFH_3$, $C_2F_4H_2$, $C_2F_5H$, $C_3F_7H$, $C_3F_6H_2$, $C_3F_5H_3$, $C_3F_4H_4$, and $C_3F_3H_5$. These additive gases may be used alone or in combination of two or more types.

The content of the dilution gas is preferably 90% by volume or less and more preferably 50% by volume or less based on the total amount of the etching gas. The content of the additive gas is preferably 50% by volume or less and more preferably 30% by volume or less based on the total amount of the etching gas.

From the viewpoint of improving the etching rate, the content of the fluorobutenes above is preferably 5% by volume or more and more preferably 10% by volume or more based on the total amount of the etching gas. From the viewpoint of suppressing the used amount of the fluorobutenes above, the content of the fluorobutenes above is preferably 90% by volume or less and more preferably 80% by volume or less based on the total amount of the etching gas.

[Method for producing etching gas]

The method for producing the etching gas according to this embodiment includes the dehydration step of applying the dehydration treatment to the crude fluorobutene which is the fluorobutene containing the water and the oxygen gas and the deoxidizing gas step of applying the deoxidizing gas treatment to the crude fluorobutene as described above.

A method for the dehydration treatment of removing the water from the crude fluorobutene is not particularly limited, and a known method can be employed. For example, treatment of bringing the crude fluorobutene into contact with an adsorbent can be employed. The dehydration treatment can be performed by bringing the crude fluorobutene into contact with an adsorbent and causing the adsorbent to adsorb the water. By bringing the crude fluorobutene into contact with the adsorbent, at least one of carbonyl fluoride and hydrogen fluoride is removed from the crude fluorobutene together with the water in some cases.

The type of the adsorbent is not particularly limited insofar as the water can be removed from the fluorobutenes above. Examples thereof include a molecular sieve 3A, a molecular sieve 4A, a molecular sieve 5A, activated carbon, silica gel, and the like, for example. Among these exemplified adsorbents, the molecular sieve 3A capable of selectively adsorbing the water is more preferable.

As the adsorbent removing carbonyl fluoride, the above-described various molecular sieves are usable. As the adsorbent removing hydrogen fluoride, the above-described various molecular sieves and metal fluorides, such as sodium fluoride, are usable.

When the crude fluorobutene is brought into contact with the adsorbent, gaseous fluorobutene may be brought into contact with the adsorbent or liquid fluorobutene may be brought into contact with the adsorbent. The contact between the crude fluorobutene and the adsorbent may be performed by a circulation method or a batch method. However, to reduce the moisture concentration in the fluorobutenes above as much as possible, it is more preferable to employ a method for bringing the liquid fluorobutene into contact with the adsorbent by the batch method for 24 hours or more.

The moisture concentration in the fluorobutenes above is set by the dehydration treatment to preferably 500 ppm by mass or less, more preferably 100 ppm by mass or less, and still more preferably 10 ppm by mass or less. Thus, the formation of carbonyl fluoride and hydrogen fluoride due to the reaction represented by the formula above is difficult to occur.

A method for measuring the moisture concentration in the fluorobutenes above is not particularly limited, and the moisture concentration can be quantified by Karl Fischer's method, for example.

A method for the deoxidizing gas treatment of removing the oxygen gas from the crude fluorobutene is not particularly limited, and for example, treatment of distilling the crude fluorobutene and separating the oxygen gas can be employed. By distilling the crude fluorobutene, at least one of carbonyl fluoride and hydrogen fluoride is removed together with the oxygen gas from the crude fluorobutene in some cases.

The distillation method is not particularly limited insofar as the oxygen gas can be separated from the crude fluorobutene, and a batch type distillation method or a continuous distillation method can be employed, for example. The type of a distillation column used for the distillation is not particularly limited, and plate columns using sieve trays, bubble cap trays, and the like or packed columns packed with regular packing or irregular packing are usable, for example.

Distillation conditions are not particularly limited, and the theoretical plate number is preferably 1 or more and 30 or less and more preferably 3 or more and 10 or less.

The temperature of the column bottom (pot) of the distillation column into which the crude fluorobutene is charged when performing the distillation is not particularly limited and is set to preferably 10°C or more and 80°C or less and more preferably 20°C or more and 60°C or less.

The temperature of the column top of the distillation column is not particularly limited and is set to preferably -60°C or more and 0°C or less and more preferably -50°C or more and -20°C or less.

The oxygen concentration in the fluorobutenes above is set by the deoxidizing gas treatment to preferably 1000 ppm by mass or less, more preferably 500 ppm by mass or less, and still more preferably 100 ppm by mass or less. Thus, the formation of carbonyl fluoride and hydrogen fluoride due to the reaction represented by the formula above is difficult to occur.

A method for measuring the oxygen concentration in the fluorobutenes above is not particularly limited and the oxygen concentration can be quantified, for example, by gas chromatography.

The method for producing the etching gas according to this embodiment may further include a filling step of filling a filling vessel with the fluorobutenes above in which the contents of the oxygen gas and the water are reduced by the implementation of the dehydration step and the deoxidizing gas step.

When the etching gas is a mixed gas containing the fluorobutenes above and the dilution gas, it may be acceptable that the fluorobutenes above and the dilution gas are mixed to form a mixed gas, and then the mixed gas is filled into the filling vessel or it may be acceptable that the fluorobutenes above and the dilution gas are separately filled into the filling vessel to form a mixed gas within the filling vessel.

A method for filling the fluorobutenes above into the filling vessel is not particularly limited, and a vapor phase filling method or a liquid phase filling method can be employed, for example. When the fluorobutene is filled into the filling vessel, the oxygen gas in the filling vessel may be removed in advance by a heat evacuation method or the like.

A material of the filling vessel is not particularly limited. Examples thereof include manganese steel, stainless steel, Hastelloy (registered trademark), and Inconel (registered trademark), for example.

[Etching method]

The etching in this embodiment can be achieved by either plasma etching using plasma or plasma-less etching not using plasma. Examples of the plasma etching include Reactive Ion Etching (RIE), Inductively Coupled Plasma (ICP) etching, Capacitively Coupled Plasma (CCP) etching, Electron Cyclotron Resonance (ECR) plasma etching, and microwave plasma etching, for example.

In the plasma etching, the plasma may be generated in a chamber where the member to be etched is installed, or a plasma generation chamber and the chamber where the member to be etched is installed may be separated (i.e., remote plasma may be used). By the etching using the remote plasma, the etching object containing silicon can be etched with higher selectivity in some cases.

Further, in the etching method according to this embodiment, the etching may be performed using the etching gas filled into a filling vessel. More specifically, the etching gas is filled into the filling vessel, the concentration of carbonyl fluoride in a gas phase part in the filling vessel is 100 ppm by mass or less, and, in the etching step, the etching object may be etched by extracting the gas phase part from the filling vessel and bringing the same into contact with the member to be etched.

[Pressure condition of etching step]

The pressure condition of the etching step in the etching method according to this embodiment is not particularly limited and is preferably set to 10 Pa or less and more preferably set to 5 Pa or less. When the pressure condition is within the ranges above, plasma is easily stably generated. The pressure condition in the etching step is preferably 0.05 Pa or more. When the pressure condition is within the range above, a large number of ionization ions are generated and a sufficient plasma density is easily obtained.

The flow rate of the etching gas may be set as appropriate such that the pressure inside the chamber is kept constant according to the size of a chamber and the capacity of exhaust equipment reducing the pressure inside the chamber.

[Temperature condition of etching step]

The temperature condition of the etching step in the etching method according to this embodiment is not particularly limited. The temperature is set to preferably 200°C or less to obtain high etching selectivity, more preferably 150°C or less to suppress the etching of the non-etching object, such as a mask, and still more preferably 100°C or less to perform anisotropic etching. Herein, the temperature of the temperature condition is the temperature of the member to be etched, but it is also possible to use the temperature of a stage installed in a chamber of an etching system and supporting the member to be etched.

The fluorobutenes above hardly react with the non-etching object, such as a mask, at temperatures equal to or less than 200°C. Therefore, when the member to be etched is etched by the etching method according to this embodiment, the etching object can be selectively etched while the non-etching object is hardly etched. Therefore, the etching method according to this embodiment can be utilized for a method for processing the etching object containing silicon into a predetermined shape utilizing the non-etching object subjected to patterning as a resist or a mask.

When the temperatures of the etching object and the non-etching object are 200°C or less, the etching selectivity tends to increase. For example, the etching selectivity ratio which is the ratio of the etching rate of the etching object containing silicon to the etching rate of the non-etching object tends to be 10 or more.

A bias power constituting a potential difference between the plasma to be generated when performing etching and the member to be etched may be selected from 0 to 10000 W depending on a desired etching shape and is preferably about 0 to 1000 W when performing selective etching. This potential difference enables the anisotropic etching.

[Member to be etched]

The member to be etched which is etched by the etching method according to this embodiment has the etching object and the non-etching object, but a member having a part formed of the etching object and a part formed of the non-etching object may be acceptable or a member formed of a mixture of the etching object and the non-etching object may be acceptable. The member to be etched may have something other than the etching object and the non-etching object.

The shape of the member to be etched is not particularly limited, and may be a plate shape, a foil shape, a film shape, a powder shape, or a block shape, for example. Examples of the member to be etched include the aforementioned semiconductor substrate.

[Etching object]

The etching object may be one formed of only materials containing silicon, may be one having a part formed of only materials containing silicon and a part formed of the other materials, or may be one formed of a mixture of materials containing silicon and the other materials. Examples of the materials containing silicon include silicon oxides, silicon nitrides, polysilicon, and silicon germanium (SiGe), for example.

Examples of the silicon oxides include silicon dioxide ($SiO_2$). The silicon nitrides refer to compounds containing silicon and nitrogen in an arbitrary ratio, and $Si_3N_4$ can be mentioned as an example. The purity of the silicon nitrides is not particularly limited, and is preferably 30% by mass or more, more preferably 60% by mass or more, and still more preferably 90% by mass or more.

The shape of the etching object is not particularly limited, and may be a plate shape, a foil shape, a film shape, a powder shape, or a block shape, for example.

[Non-etching object]

The non-etching object does not substantially react with the fluorobutenes above or extremely slowly reacts with the fluorobutenes above, and therefore, even when the etching is performed by the etching method according to this embodiment, the etching hardly proceeds. The non-etching object is not particularly limited insofar as it has the above-described properties. Examples of the non-etching object include a photoresist, amorphous carbon (C), titanium nitride (TiN), metals, such as copper (Cu), nickel (Ni), and cobalt (Co), and oxides and nitrides of these metals, for example. Among the above, a photoresist and amorphous carbon are more preferable from the viewpoint of handleability and availability.

The photoresist means a photosensitive composition having physical properties, such as solubility, changed by light or electron beams. For example, photoresists for g-line, h-line, i-line, KrF, ArF, F2, EUV, and the like are mentioned. The composition of the photoresist is not particularly limited insofar as it is commonly used in a semiconductor production step. Examples thereof include compositions containing a polymer synthesized from at least one monomer selected from chain olefins, cyclic olefins, styrene, vinylphenol, acrylic acid, methacrylate, epoxy, melamine, and glycol, for example.

Further, the non-etching object is usable as a resist or a mask for suppressing the etching of the etching object by the etching gas. Therefore, the etching method according to this embodiment is usable for a method for processing the etching object into a predetermined shape (for example, processing the etching object in a film shape possessed by the member to be etched to have a predetermined film thickness) utilizing the non-etching object subjected to patterning as a resist or a mask, for example, and therefore can be suitably used for producing a semiconductor device. Further, the non-etching object is hardly etched, and therefore it is possible to suppress the etching of parts not to be etched of the semiconductor device and to prevent the loss of the properties of the semiconductor device by the etching.

The non-etching object left after the patterning can be removed by a removal method commonly used in a semiconductor device production step. For example, ashing using an oxidizing gas, such as oxygen plasma or ozone, or dissolving and removing using a chemical solution, such as APM (mixed liquid of ammonia water and hydrogen peroxide water), SPM (mixed liquid of sulfuric acid and hydrogen peroxide), or an organic solvent, is mentioned.

Next, one example of the configuration of an etching system capable of implementing the etching method according to this embodiment and one example of an etching method using the etching system are described with reference to FIG. 1. The etching system in FIG. 1 is a plasma etching system performing etching using plasma. First, the etching system in FIG. 1 is described.

The etching system in FIG. 1 includes a chamber 10 inside which etching is performed, a plasma generation device (not illustrated) generating plasma into the chamber 10, a stage 11 supporting an etching member 12 to be etched inside the chamber 10, a thermometer 14 measuring the temperature of the member to be etched 12, an exhaust pipe 13 for exhausting gas inside the chamber 10, a vacuum pump 15 provided in the exhaust pipe 13 and reducing the pressure inside the chamber 10, and a pressure gauge 16 measuring the pressure inside the chamber 10. When the stage 11 is connected to a high frequency power source, a function of applying a high frequency to the member to be etched 12 can be imparted to the stage 11.

The type of the plasma generating mechanism of the plasma generation device is not particularly limited, and may be one of applying a high frequency voltage to parallel plates or one of passing a high frequency current through a coil. When a high frequency voltage is applied to the member to be etched 12 in the plasma, a negative voltage is applied to the member to be etched 12, and positive ions enter the member to be etched 12 at high speed and perpendicularly, so that anisotropic etching is enabled.

The etching system of FIG. 1 further includes an etching gas supply unit supplying an etching gas into the chamber 10. The etching gas supply unit includes a fluorobutene gas supply unit 1 supplying a gas of fluorobutene, a dilution gas supply unit 2 supplying a dilution gas, a fluorobutene gas supply pipe 5 connecting the fluorobutene gas supply unit 1 and the chamber 10, and a dilution gas supply pipe 6 connecting the dilution gas supply unit 2 to an intermediate part of the fluorobutene gas supply pipe 5.

The fluorobutene gas supply pipe 5 is further provided with a fluorobutene gas pressure control device 7 controlling the pressure of the fluorobutene gas and a fluorobutene gas flow rate control device 3 controlling the flow rate of the fluorobutene gas. The dilution gas supply pipe 6 is further provided with a dilution gas pressure control device 8 controlling the pressure of the dilution gas and a dilution gas flow rate control device 4 controlling the flow rate of the dilution gas. Equipment supplying an additive gas in the same manner as the dilution gas supply unit 2, the dilution gas flow rate control device 4, the dilution gas supply pipe 6, and the dilution gas pressure control device 8 may be also installed (not illustrated).

When the fluorobutene gas is supplied as the etching gas to the chamber 10, the pressure inside the chamber 10 is reduced by the vacuum pump 15, and then the fluorobutene gas is sent from the fluorobutene gas supply unit 1 to the fluorobutene gas supply pipe 5, so that the fluorobutene gas is supplied to the chamber 10 via the fluorobutene gas supply pipe 5.

When a mixed gas of the fluorobutene gas and a dilution gas, such as an inert gas, is supplied as the etching gas, the pressure inside the chamber 10 is reduced by the vacuum pump 15, and then the fluorobutene gas is sent from the fluorobutene gas supply unit 1 to the fluorobutene gas supply pipe 5 and the dilution gas is sent from the dilution gas supply unit 2 to the fluorobutene gas supply pipe 5 through the dilution gas supply pipe 6. Thus, the fluorobutene gas and the dilution gas are mixed in the intermediate part of the fluorobutene gas supply pipe 5 to form a mixed gas, and the mixed gas is supplied to the chamber 10 via the fluorobutene gas supply pipe 5. The fluorobutene gas and the dilution gas may be separately supplied to the chamber 10 and formed into a mixed gas in the chamber 10.

The configurations of the fluorobutene gas supply unit 1 and the dilution gas supply unit 2 are not particularly limited and tanks, cylinders, or the like may be acceptable, for example. As the fluorobutene gas flow rate control device 3 and the dilution gas flow rate control device 4, a mass flow controller, a flow meter, and the like can be utilized, for example.

When the etching gas is supplied to the chamber 10, the etching gas is preferably supplied while the supply pressure of the etching gas (i.e., the value of the fluorobutene gas pressure control device 7 in FIG. 1) is held at a predetermined value. More specifically, the supply pressure of the etching gas is preferably set to 1 Pa or more and 0.2 MPa or less, more preferably 10 Pa or more and 0.1 MPa or less, and still more preferably 50 Pa or more and 50 kPa or less. When the supply pressure of the etching gas is within the ranges above, the etching gas is smoothly supplied to the chamber 10 and a load to the parts (for example, the various devices and pipes) possessed by the etching system illustrated in FIG. 1 is small.

The pressure of the etching gas supplied into the chamber 10 is preferably 1 Pa or more and 80 kPa or less, more preferably 10 Pa or more and 50 kPa or less, and still more preferably 100 Pa or more and 20 kPa or less from the viewpoint of uniformly etching the surface of the member to be etched 12. When the pressure of the etching gas in the chamber 10 is within the ranges above, a sufficient etching rate can be obtained and the etching selectivity ratio tends to be high.

The pressure inside the chamber 10 before the etching gas is supplied is not particularly limited insofar as it is equal to or less than the supply pressure of the etching gas or less than the supply pressure of the etching gas, and is preferably $10^{-5}$ Pa or more and less than 10 kPa and more preferably 1 Pa or more and 2 kPa or less, for example.

A differential pressure between the supply pressure of the etching gas and the pressure inside the chamber 10 before the etching gas is supplied is preferably 0.5 MPa or less, more preferably 0.3 MPa or less, and still more preferably 0.1 MPa or less. When the differential pressure is within the ranges above, the etching gas is easily smoothly supplied to the chamber 10.

When the etching gas is supplied to the chamber 10, it is preferable to supply the etching gas while the temperature of the etching gas is held at a predetermined value. More specifically, the supply temperature of the etching gas is preferably 0°C or more and 150°C or less.

An etching treatment time (hereinafter also referred to as "etching time") can be arbitrarily set depending on how much the etching object possessed by the member to be etched 12 is desired to be etched and is preferably within 60 minutes, more preferably within 40 minutes, and still more preferably within 20 minutes considering the production efficiency of a semiconductor device producing process. The etching treatment time refers to a time during which the etching gas is brought into contact with the member to be etched 12 inside the chamber 10.

The etching method according to this embodiment can be performed using a common plasma etching system used in the semiconductor device production step, such as the etching system in FIG. 1, and the configuration of the usable etching system is not particularly limited.

For example, the positional relationship between the fluorobutene gas supply pipe 5 and the member to be etched 12 is not particularly limited insofar as the etching gas can be brought into contact with the member to be etched 12. Also with respect to the configuration of a temperature control mechanism of the chamber 10, it is sufficient when the temperature of the member to be etched 12 can be adjusted to any temperature. Therefore, a configuration may be acceptable in which the temperature control mechanism of the member to be etched 12 is provided directly on the stage 11 or the chamber 10 may be warmed or cooled from the outside of the chamber 10 using the temperature control mechanism externally attached.

A material of the etching system in FIG. 1 is not particularly limited insofar as it has corrosion resistance to the fluorobutene to be used and can be subjected to a pressure reduction to a predetermined pressure. For example, metals, such as nickel, nickel-based alloys, aluminum, stainless steel, platinum, copper, and cobalt, ceramics, such as alumina ($Al_2O_3$), fluororesins, and the like are usable for portions contacting the etching gas.

Specific examples of the nickel-based alloys include Inconel (registered trademark), Hastelloy (registered trademark), Monel (registered trademark), and the like. Examples of the fluororesins include polytetrafluoroethylene (PTFE), polychlorotrifluoroethylene (PCTFE), a tetrafluoroethylene-perfluoroalkoxyethylene copolymer (PFA), polyvinylidene fluoride (PVDF), Teflon (registered trademark), Viton (registered trademark), Kalrez (registered trademark), and the like, for example.

EXAMPLES

Hereinafter, the present invention is more specifically described with reference to Examples and Comparative Examples. Fluorobutenes containing carbonyl fluoride and hydrogen fluoride as the impurities in various concentrations were prepared. Preparation examples of the fluorobutene are described below.

(Preparation example 1)

1,1,1,4,4,4-hexafluoro-2-butene filled into a 10 L capacity manganese steel vessel was prepared.

When a gas phase part of the 1,1,1,4,4,4-hexafluoro-2-butene was extracted from the manganese steel vessel, and the oxygen concentration was measured, the oxygen concentration was 1103 ppm by mass. When a liquid phase part of the 1,1,1,4,4,4-hexafluoro-2-butene was extracted from the manganese steel vessel, and the moisture concentration was measured, the moisture concentration was 384 ppm by mass.

The oxygen concentration was measured using a gas chromatograph GC-2014 manufactured by Shimadzu Corporation. The moisture concentration was measured using a Karl Fischer moisture meter CA-310 manufactured by Mitsubishi Chemical Analytech Co., Ltd.

Next, the 1,1,1,4,4,4-hexafluoro-2-butene above was subjected to dehydration treatment as described below. A 1 L capacity cylinder formed of stainless steel SUS316 was filled with 100 mL of a molecular sieve 3A manufactured by UNION SHOWA K.K. and sealed. The pressure inside the cylinder was reduced while heating the cylinder, and the cylinder was cooled to -78°C. 500 g of the 1,1,1,4,4,4-hexafluoro-2-butene was transferred to the cooled cylinder from the manganese steel vessel, and the 1,1,1,4,4,4-hexafluoro-2-butene was brought into contact with the molecular sieve 3A, thereby performing dehydration treatment.

The temperature of the cylinder was returned to room temperature, and then the cylinder was allowed to stand still in a room controlled to 20°C for 24 hours. Then, when a liquid phase part was extracted from the cylinder after allowed to stand still, and the moisture concentration of the 1,1,1,4,4,4-hexafluoro-2-butene was measured, the moisture concentration was 2 ppm by mass. A method for measuring the moisture concentration is the same as above.

Subsequently, the 1,1,1,4,4,4-hexafluoro-2-butene, which had been subjected to the dehydration treatment as described above, was subjected to deoxidizing gas treatment as described below using a refining apparatus provided with a SUS distillation column, a 5 L capacity pot, a condenser, a receiver for a fraction of distillation, and the like. 500 g of the 1,1,1,4,4,4-hexafluoro-2-butene which had been subjected to the dehydration treatment as described above was charged into the pot, and the pot was heated to 30°C for distillation. The used SUS distillation column is packed with a laboratory packing manufactured by Sulzer Chemtech, and has 10 theoretical plates. The temperature of the condenser was set to -40°C.

When the temperature of a column top part of the distillation column reached -40°C, 50 g of the fraction of distillation was extracted into the receiver. Then, the distillation was stopped, the gas phase part of the 1,1,1,4,4,4-hexafluoro-2-butene remaining in the pot was extracted, and the oxygen concentration was measured to be 4 ppm by mass. A method for measuring the oxygen concentration is the same as described above.

Next, a 1 L capacity SUS316 cylinder (hereinafter referred to as "cylinder A") was prepared. The cylinder A was filled with 400 g of the 1,1,1,4,4,4-hexafluoro-2-butene remaining in the pot of the refining apparatus after the deoxidizing gas treatment was completed by gas phase filling (filling step). Then, the cylinder A was allowed to stand still in a room controlled to 20°C for 30 days. The 1,1,1,4,4,4-hexafluoro-2-butene in the cylinder A after allowed to stand still for 30 days is defined as a sample 1-1.

When a gas phase part of the 1,1,1,4,4,4-hexafluoro-2-butene of the sample 1-1 was extracted from the cylinder A and the concentration of carbonyl fluoride was measured, the concentration of carbonyl fluoride was less than 10 ppm by mass. The concentration of carbonyl fluoride was measured using an infrared spectrophotometer Nicolet iS10 manufactured by Thermo Fisher Scientific.

Next, three 500 mL capacity SUS316 cylinders (hereafter referred to as "cylinder B", "cylinder C", and "cylinder D") were prepared, and 100 g of the 1,1,1,4,4,4-hexafluoro-2-butene was transferred to each of these cylinders B, C, and D from the manganese steel vessel (filling step). Then, in a room controlled to 20°C, the cylinder B was allowed to stand still for 10 days, the cylinder C was allowed to stand still for 20 days, and the cylinder D was allowed to stand still for 30 days.

The 1,1,1,4,4,4-hexafluoro-2-butene in the cylinder B after allowed to stand still is defined as a sample 1-2, the 1,1,1,4,4,4-hexafluoro-2-butene in the cylinder C after allowed to stand still is defined as a sample 1-3, and the 1,1,1,4,4,4-hexafluoro-2-butene in the cylinder D after allowed to stand still is defined as a sample 1-4.

When a gas phase part of the 1,1,1,4,4,4-hexafluoro-2-butene of the sample 1-2 was extracted from the cylinder B, and the concentration of carbonyl fluoride was measured, the concentration of carbonyl fluoride was 211 ppm by mass.

Similarly, when a gas phase part of the 1,1,1,4,4,4-hexafluoro-2-butene of the sample 1-3 was extracted from the cylinder C, and the concentrations of carbonyl fluoride and hydrogen fluoride were measured, the concentration of carbonyl fluoride was 408 ppm by mass and the concentration of hydrogen fluoride was 392 ppm by mass. The concentration of hydrogen fluoride was measured using an infrared spectrophotometer Nicolet iS10 manufactured by Thermo Fisher Scientific.

Similarly, when a gas phase part of the 1,1,1,4,4,4-hexafluoro-2-butene of the sample 1-4 was extracted from the cylinder D, and the concentration of carbonyl fluoride was measured, the concentration of carbonyl fluoride was 589 ppm by mass.

(Preparation example 2)

1,1,1,2,4,4,4-heptafluoro-2-butene filled into a 10 L capacity manganese steel vessel was prepared. When a gas phase part of the 1,1,1,2,4,4,4-heptafluoro-2-butene was extracted from the manganese steel vessel, and the oxygen concentration was measured, the oxygen concentration was 1225 ppm by mass. When a liquid phase part of the 1,1,1,2,4,4,4-heptafluoro-2-butene was extracted from the manganese steel vessel, and the moisture concentration was measured, the moisture concentration was 382 ppm by mass. Methods for measuring the moisture concentration and the oxygen concentration are the same as above.

Samples 2-1 to 2-4 were prepared in the same manner as in Preparation example 1, except that the 1,1,1,2,4,4,4-heptafluoro-2-butene above was used as fluorobutene. Then, the concentration of carbonyl fluoride of each sample and the concentration of hydrogen fluoride of the sample 2-3 were measured. Measuring methods are the same as above.

The concentration of carbonyl fluoride of the sample 2-1 was less than 10 ppm by mass.

The concentration of carbonyl fluoride of the sample 2-2 was 268 ppm by mass.

The concentration of carbonyl fluoride of the sample 2-3 was 478 ppm by mass and the concentration of hydrogen fluoride thereof was 155 ppm by mass.

The concentration of carbonyl fluoride of the sample 2-4 was 653 ppm by mass.

(Preparation example 3)

2,3,3,4,4,4-hexafluoro-1-butene filled into a 10 L capacity manganese steel vessel was prepared. When a gas phase part of the 2,3,3,4,4,4-hexafluoro-1-butene was extracted from the manganese steel vessel, and the oxygen concentration was measured, the oxygen concentration was 1313 ppm by mass. When a liquid phase part of the 2,3,3,4,4,4-hexafluoro-1-butene was extracted from the manganese steel vessel, and the moisture concentration was measured, the moisture concentration was 411 ppm by mass. Methods for measuring the moisture concentration and the oxygen concentration are the same as above.

Samples 3-1 to 3-4 were prepared in the same manner as in Preparation example 1, except that the 2,3,3,4,4,4-hexafluoro-1-butene above was used as fluorobutene. Then, the concentration of carbonyl fluoride of each sample and the concentration of hydrogen fluoride of the sample 3-3 were measured. Measuring methods are the same as above.

The concentration of carbonyl fluoride of the sample 3-1 was less than 10 ppm by mass.

The concentration of carbonyl fluoride of the sample 3-2 was 235 ppm by mass.

The concentration of carbonyl fluoride of the sample 3-3 was 411 ppm by mass and the concentration of hydrogen fluoride thereof was 408 ppm by mass.

The concentration of carbonyl fluoride of the sample 3-4 was 603 ppm by mass.

(Preparation example 4)

1,1,3,3,4,4-heptafluoro-1-butene filled into a 10 L capacity manganese steel vessel was prepared. When a gas phase part of the 1,1,3,3,4,4,4-heptafluoro-1-butene was extracted from the manganese steel vessel, and the oxygen concentration was measured, the oxygen concentration was 1003 ppm by mass. When a liquid phase part of the 1,1,3,3,4,4,4-heptafluoro-1-butene was extracted from the manganese steel vessel, and the moisture concentration was measured, the moisture concentration was 391 ppm by mass. Methods for measuring the moisture concentration and the oxygen concentration are the same as above.

Samples 4-1 to 4-4 were prepared in the same manner as in Preparation example 1, except that the 1,1,3,3,4,4,4-heptafluoro-1-butene above was used as fluorobutene. Then, the concentration of carbonyl fluoride of each sample and the concentration of hydrogen fluoride of the sample 4-3 were measured. Measuring methods are the same as above.

The concentration of carbonyl fluoride of the sample 4-1 was less than 10 ppm by mass.

The concentration of carbonyl fluoride of the sample 4-2 was 268 ppm by mass.

The concentration of carbonyl fluoride of the sample 4-3 was 437 ppm by mass and the concentration of hydrogen fluoride thereof was 36 ppm by mass.

The concentration of carbonyl fluoride of the sample 4-4 was 622 ppm by mass.

Table 1 shows the concentrations of carbonyl fluoride and hydrogen fluoride of each sample.

[Table 1]

| Sample | Type of fluorobutene | Concentration of $COF_2$ (ppm by mass) | Concentration of HF (ppm by mass) |
|---|---|---|---|
| 1-1 | 1,1,1,4,4,4-hexafluoro-2-butene | Less than 10 | - |
| 1-2 | 1,1,1,4,4,4-hexafluoro-2-butene | 211 | - |
| 1-3 | 1,1,1,4,4,4-hexafluoro-2-butene | 408 | 392 |
| 1-4 | 1,1,1,4,4,4-hexafluoro-2-butene | 589 | - |
| 2-1 | 1,1,1,2,4,4,4-heptafluoro-2-butene | Less than 10 | - |
| 2-2 | 1,1,1,2,4,4,4-heptafluoro-2-butene | 268 | - |
| 2-3 | 1,1,1,2,4,4,4-heptafluoro-2-butene | 478 | 155 |
| 2-4 | 1,1,1,2,4,4,4-heptafluoro-2-butene | 653 | - |
| 3-1 | 2,3,3,4,4,4-hexafluoro-1-butene | Less than 10 | - |
| 3-2 | 2,3,3,4,4,4-hexafluoro-1-butene | 235 | - |
| 3-3 | 2,3,3,4,4,4-hexafluoro-1-butene | 411 | 408 |
| 3-4 | 2,3,3,4,4,4-hexafluoro-1-butene | 603 | - |
| 4-1 | 1,1,3,3,4,4,4-heptafluoro-1-butene | Less than 10 | - |
| 4-2 | 1,1,3,3,4,4,4-heptafluoro-1-butene | 268 | - |
| 4-3 | 1,1,3,3,4,4-heptafluoro-1-butene | 437 | 36 |

(continued)

| Sample | Type of fluorobutene | Concentration of $COF_2$ (ppm by mass) | Concentration of HF (ppm by mass) |
|---|---|---|---|
| 4-4 | 1,1,3,3,4,4,4-heptafluoro-1-butene | 622 | - |
| *) "-" indicates that there is no measurement data. | | | |

(Example 1)

A silicon oxide film with a thickness of 1000 nm, a silicon nitride film with a thickness of 1000 nm, and a photoresist film with a thickness of 1000 nm were individually formed on the surface of a semiconductor wafer to be exposed to the surface without lamination, and the resultant was used as a test specimen. Then, the test specimen was etched using the 1,1,1,4,4,4-hexafluoro-2-butene of the sample 1-1.

As an etching system, an ICP etching system RIE-230iP manufactured by Samco Inc., was used. Specifically, the 1,1,1,4,4,4-hexafluoro-2-butene of the sample 1-1 at a flow rate of 10 mL/min and argon at a flow rate of 40 mL/min were individually and independently introduced into a chamber and mixed in the chamber to give an etching gas in the chamber, and a high frequency voltage was applied at 500 W to convert the etching gas into plasma in the chamber. Then, the test specimen in the chamber was etched under etching conditions of a pressure of 3 Pa, a temperature of 20°C, and a bias power of 100 W. When the concentrations of carbonyl fluoride and hydrogen fluoride of argon used herein was measured, neither was detected.

After the etching was completed, the test specimen was taken out from the chamber, the thicknesses of the silicon oxide film, the silicon nitride film, and the photoresist film were measured, and the thickness reduction amount from the thickness of each film before the etching was calculated. The etching rate of each film was calculated by dividing the reduction amount by the etching time. As a result, the etching rate of the photoresist film was less than 1 nm/min, the etching rate of the silicon oxide film was 43 nm/min, and the etching rate of the silicon nitride film was 51 nm/min. It was confirmed from this result that the silicon oxide film and the silicon nitride film, which are the etching objects, were selectively etched as compared with the photoresist film, which is the non-etching object.

(Example 2)

A test specimen was etched in the same manner as in Example 1, except for using the 1,1,1,4,4,4-hexafluoro-2-butene of the sample 1-2 in place of the sample 1-1, and the etching rate of each film was calculated.

As a result, the etching rate of the photoresist film was 2 nm/min, the etching rate of the silicon oxide film was 47 nm/min, and the etching rate of the silicon nitride film was 53 nm/min. It was confirmed from this result that the silicon oxide film and the silicon nitride film, which are the etching objects, were selectively etched as compared with the photoresist film, which is the non-etching object.

(Example 3)

A test specimen was etched in the same manner as in Example 1, except for using the 1,1,1,4,4,4-hexafluoro-2-butene of the sample 1-3 in place of the sample 1-1, and the etching rate of each film was calculated.

As a result, the etching rate of the photoresist film was 5 nm/min, the etching rate of the silicon oxide film was 55 nm/min, and the etching rate of the silicon nitride film was 59 nm/min. It was confirmed from this result that the silicon oxide film and the silicon nitride film, which are the etching objects, were selectively etched as compared with the photoresist film, which is the non-etching object.

(Comparative Example 1)

A test specimen was etched in the same manner as in Example 1, except for using the 1,1,1,4,4,4-hexafluoro-2-butene of the sample 1-4 in place of the sample 1-1, and the etching rate of each film was calculated.

As a result, the etching rate of the photoresist film was 18 nm/min, the etching rate of the silicon oxide film was 61 nm/min, and the etching rate of the silicon nitride film was 64 nm/min. It was confirmed from this result that the etching selectivity of the silicon oxide film and the silicon nitride film, which are the etching objects, to the photoresist film, which is the non-etching object, decreases.

(Example 4)

A SUS tube with a diameter of 0.5 inch and a length of 10 cm was filled with 10 mL of a molecular sieve 5A manufactured by UNION SHOWA K.K. After allowed to stand still for 10 days, the cylinder B containing the 1,1,1,4,4,4-hexafluoro-2-butene of the sample 1-2 was connected to the SUS tube filled with the molecular sieve 5A, and the 1,1,1,4,4,4-hexafluoro-2-butene of the sample 1-2 was passed through the SUS tube at a flow rate of 100 mL/min from the cylinder B. Then, the concentrations of carbonyl fluoride and hydrogen fluoride of the 1,1,1,4,4,4-hexafluoro-2-butene coming out from an outlet through the inside of the SUS tube were measured. Measuring methods are the same as above. As a result, both the concentration of carbonyl fluoride and the concentration of hydrogen fluoride were less than 10 ppm by mass.

Next, the same etching as that in Example 1 was performed while the outlet of the SUS tube was connected to a reaction chamber of the etching system, and the 1,1,1,4,4,4-hexafluoro-2-butene coming out of the outlet through the inside of the SUS tube was introduced into the reaction chamber.

As a result, the etching rate of the photoresist film was less than 1 nm/min, the etching rate of the silicon oxide film was 44 nm/min, and the etching rate of the silicon nitride film was 53 nm/min. It was confirmed from this result that the silicon oxide film and the silicon nitride film, which are the etching objects, were selectively etched as compared with the photoresist film, which is the non-etching object.

(Examples 5 to 13 and Comparative Examples 2 to 4) Test specimens were etched in the same manner as in Example 1, except for using samples illustrated in Table 2 in place of the sample 1-1, and the etching rate of each film was calculated. Table 2 shows the results.

[Table 2]

| | Sample | Etching gas | | | | | Etching rate (nm/min) | | |
| | | Flow rate (mL/min) | Dilution gas | Flow rate (mL/min) | Concentration of $COF_2$ (ppm by mass) | Concentration of HF (ppm by mass) | Non-etching object | Etching object | |
| | | | | | | | Photoresist film | Silicon oxide film | Silicon nitride film |
|---|---|---|---|---|---|---|---|---|---|
| Ex. 1 | 1-1 | 10 | Ar | 40 | Less than 2 | - | Less than 1 | 43 <more than 43> | 51 <more than 51> |
| Ex. 2 | 1-2 | 10 | Ar | 40 | 42 | - | 2 | 47 <24> | 53 <27> |
| Ex. 3 | 1-3 | 10 | Ar | 40 | 82 | 78 | 5 | 55 <11> | 59 <12> |
| Comp. Ex. 1 | 1-4 | 10 | Ar | 40 | 118 | - | 18 | 61 <3> | 64 <4> |
| Ex. 4 | 1-2 | 100 | None | None | Less than 10 | Less than 10 | Less than 1 | 44 <more than 44> | 53 <more than 53> |
| Ex. 5 | 2-1 | 10 | Ar | 40 | Less than 2 | - | Less than 1 | 41 <more than 41> | 55 <more than 55> |
| Ex. 6 | 2-2 | 10 | Ar | 40 | 54 | - | Less than 1 | 44 <more than 44> | 56 <more than 56> |
| Ex. 7 | 2-3 | 10 | Ar | 40 | 96 | 31 | 3 | 43 <14> | 58 <19> |
| Comp. Ex. 2 | 2-4 | 10 | Ar | 40 | 131 | - | 9 | 46 <5> | 60 <7> |
| Ex. 8 | 3-1 | 10 | Ar | 40 | Less than 2 | - | Less than 1 | 41 <more than 41> | 48 <more than 48> |
| Ex. 9 | 3-2 | 10 | Ar | 40 | 47 | - | Less than 1 | 43 <more than 43> | 54 <more than 54> |
| Ex. 10 | 3-3 | 10 | Ar | 40 | 82 | 82 | 4 | 45 <11> | 57 <14> |
| Comp. Ex. 3 | 3-4 | 10 | Ar | 40 | 121 | - | 12 | 49 <4> | 58 <5> |
| Ex. 11 | 4-1 | 10 | Ar | 40 | Less than 2 | - | Less than 1 | 37 <more than 37> | 41 <more than 41> |
| Ex. 12 | 4-2 | 10 | Ar | 40 | 54 | - | 2 | 39 <20> | 47 <24> |

EP 4 231 333 A1

(continued)

| | Sample | Flow rate (mL/min) | Dilution gas | Flow rate (mL/min) | Concentration of $COF_2$ (ppm by mass) | Concentration of HF (ppm by mass) | Etching rate (nm/min) | | |
|---|---|---|---|---|---|---|---|---|---|
| | | | | | | | Non-etching object | Etching object | |
| | | | | | | | Photoresist film | Silicon oxide film | Silicon nitride film |
| Ex. 13 | 4-3 | 10 | Ar | 40 | 87 | 7 | 4 | 44 <11> | 52 <13> |
| Comp. Ex. 4 | 4-4 | 10 | Ar | 40 | 124 | - | 11 | 48 <4> | 57 <5> |

*) "-" indicates that there is no measurement data.
*) The numeric value in <> indicates the etching selectivity ratio (Etching rate of etching object)/(Etching rate of non-etching object).

The results of Examples above show that, when the concentration of carbonyl fluoride in the etching gas is low, the etching object is selectively etched as compared with the non-etching object, and the etching selectivity ratio is 10 or more. On the other hand, the results of Comparative Examples show that, when the concentration of carbonyl fluoride in the etching gas is high, the etching selectivity of the etching object to the non-etching object decreases, and the etching selectivity ratio becomes less than 10.

Reference Signs List

| 1 | fluorobutene gas supply unit |
|---|---|
| 2 | dilution gas supply unit |
| 3 | fluorobutene gas flow rate control device |
| 4 | dilution gas flow rate control device |
| 5 | fluorobutene gas supply pipe |
| 6 | dilution gas supply pipe |
| 7 | fluorobutene gas pressure control device |
| 8 | dilution gas pressure control device |
| 10 | chamber |
| 11 | stage |
| 12 | member to be etched |
| 13 | exhaust pipe |
| 14 | thermometer |
| 15 | vacuum pump |
| 16 | pressure gauge |

**Claims**

1.  An etching gas comprising:

    fluorobutene represented by a general formula $C_4H_xF_y$, in which x is 1 or more and 7 or less, y is 1 or more and 7 or less, and x + y is 8, wherein
    the etching gas contains carbonyl fluoride as impurities and a concentration of carbonyl fluoride is 100 ppm by mass or less.

2.  The etching gas according to claim 1, further comprising hydrogen fluoride as the impurities, wherein a concentration of hydrogen fluoride is 100 ppm by mass or less.

3.  A method for producing the etching gas according to claim 1 or 2 comprising:

    a dehydration step of applying dehydration treatment to crude fluorobutene which is the fluorobutene containing water and an oxygen gas; and
    a deoxidizing gas step of applying deoxidizing gas treatment to the crude fluorobutene.

4.  The method for producing the etching gas according to claim 3, wherein the deoxidizing gas step is performed after the dehydration step.

5.  The method for producing the etching gas according to claim 3 or 4, wherein the dehydration treatment is treatment of bringing the crude fluorobutene into contact with an adsorbent to cause the adsorbent to adsorb the water.

6.  The method for producing the etching gas according to any one of claims 3 to 5, further comprising:
    a filling step of filling a filling vessel with the fluorobutene having undergone the dehydration step and the deoxidizing gas step.

7.  An etching method comprising:

    an etching step of bringing the etching gas according to claim 1 or 2 into contact with a member to be etched having an etching object which is an object to be etched by the etching gas and a non-etching object which is not an object to be etched by the etching gas, and selectively etching the etching object as compared with the non-etching object, wherein
the etching object contains silicon.

8. The etching method according to claim 7, wherein the etching gas is filled into a filling vessel, a gas phase part in the filling vessel has a concentration of carbonyl fluoride of 100 ppm by mass or less, and, in the etching step, the etching object is etched by extracting the gas phase part from the filling vessel and bringing the gas phase part into contact with the member to be etched.

9. The etching method according to claim 7 or 8, wherein the etching gas is a gas containing only the fluorobutene or a mixed gas containing the fluorobutene and a dilution gas.

10. The etching method according to claim 9, wherein the dilution gas is at least one selected from a nitrogen gas, helium, argon, neon, krypton, and xenon.

11. A method for producing a semiconductor device using the etching method according to any one of claims 7 to 10, the member to be etched being a semiconductor substrate having the etching object and the non-etching object, the method comprising:
a treatment step of removing at least a part of the etching object from the semiconductor substrate by the etching.

FIG. 1

## INTERNATIONAL SEARCH REPORT

| | International application No. |
| --- | --- |
| | **PCT/JP2021/037425** |

**A. CLASSIFICATION OF SUBJECT MATTER**

*H01L 21/3065*(2006.01)i
FI:   H01L21/302 105A; H01L21/302 301Z

According to International Patent Classification (IPC) or to both national classification and IPC

**B. FIELDS SEARCHED**

Minimum documentation searched (classification system followed by classification symbols)

H01L21/3065

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2015-533029 A (L'AIR LIQUIDE, SOCIETE ANONYME POUR L'ETUDE ET L'EXPLOITATION DES PROCEDES GEORGES CLAUDE) 16 November 2015 (2015-11-16) | 1-11 |
| A | JP 2017-92357 A (CENTRAL GLASS CO LTD) 25 May 2017 (2017-05-25) | 1-11 |
| A | JP 2014-185111 A (NIPPON ZEON CO LTD) 02 October 2014 (2014-10-02) | 1-11 |
| A | WO 2017/169809 A1 (ZEON CORP) 05 October 2017 (2017-10-05) | 1-11 |

☐ Further documents are listed in the continuation of Box C.   ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **21 December 2021** | **28 December 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2021/037425**

| Patent document cited in search report | | | Publication date (day/month/year) | Patent family member(s) | | | Publication date (day/month/year) |
|---|---|---|---|---|---|---|---|
| JP | 2015-533029 | A | 16 November 2015 | JP | 2018-50074 | A | |
| | | | | JP | 2019-195062 | A | |
| | | | | US | 2015/0294880 | A1 | |
| | | | | US | 2017/0032976 | A1 | |
| | | | | US | 2019/0326129 | A1 | |
| | | | | WO | 2014/070838 | A1 | |
| | | | | TW | 201422780 | A | |
| | | | | KR | 10-2014-0090241 | A | |
| | | | | CN | 104885203 | A | |
| | | | | KR | 10-2015-0122266 | A | |
| | | | | CN | 107275206 | A | |
| | | | | TW | 201730142 | A | |
| | | | | SG | 11201503321X | A | |
| | | | | SG | 10201703513W | A | |
| | | | | KR | 10-2019-0132564 | A | |
| JP | 2017-92357 | A | 25 May 2017 | (Family: none) | | | |
| JP | 2014-185111 | A | 02 October 2014 | (Family: none) | | | |
| WO | 2017/169809 | A1 | 05 October 2017 | US | 2019/0105588 | A1 | |
| | | | | EP | 3437709 | A1 | |
| | | | | CN | 108778451 | A | |
| | | | | KR | 10-2018-0132051 | A | |
| | | | | TW | 201800139 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6257638 B
- JP 6462699 B